# EUROPEAN PATENT APPLICATION

(11) **EP 3 035 395 A1**
(43) Date of publication of application: **22.06.2016**
(21) Application number: 14198251.2
(22) Date of filing: 16.12.2014
(51) Int. Cl.: H01L 33/50

(54) **White light emitting diode device for illumination using near UV light and phosphor**

(71) Applicant: Ledst Co., Ltd., Jeonju-si, Jeollabuk-do (KR)
(72) Inventor: An, Jong Uk, Jeonju-si, Jeollabuk-do (KR); Park, Jeong Hwan, Iksan-si, Jeollabuk-do (KR); Shim, Jai Gon, Gwangsan-gu, Gwangju (KR); Park, Noh Joon, Jeonju-si, Jeollabuk-do (KR)
(74) Representative: Schwarz & Partner

(57) **Abstract**

Provided is a white light emitting diode device having excellent characteristics by using a UV chip of a specific wavelength range as well as red, green, blue and yellow phosphors.

## Description

### [Technical Field]

The present disclosure relates to a white light emitting diode device for illumination using a near UV light and phosphors, and more particularly, to a white light emitting diode device for illumination using a near UV light and phosphors which has a high color rendering index and good light efficiency and is capable of restraining a spike and an IR light component in a blue area.

### [Background Art]

Recently, as a technique for commercializing an illumination system of a light emitting diode (LED) device using a semiconductor light emitting diode chip, a phosphor is applied to a surface of a semiconductor light emitting diode (LED) chip, phosphor is added to a resin of the LED device by a predetermined weight%, and a light color, for example a white color, other than the original color of the semiconductor light emitting diode chip which is a blue color is obtained. The existing illumination system generally uses a GaN-based semiconductor light emitting diode chip which emits a blue color with a peak wavelength of about 460 nm. However, this white LED is found to contain a lot of blue light, when spectrum analysis is applied thereto, and thus optical characteristics such as color stability and color rendering should be improved further.

### [Technical Problem]

In the existing illumination system using a semiconductor light emitting diode chip, color stability is insufficient since a light irradiation surface is stained due to a strong wavelength of the emitted blue light, which is an excited light, and thus it is difficult to obtain a high color rendering index. The present disclosure is directed to providing a white light emitting diode device for illumination, which may solve the above problem of an existing illumination system and also give a light emission spectrum without a halogen lamp to which a daylight filter is mounted, thereby ensuring an excellent color rendering index and good color stability.

### [Technical Solution]

In one general aspect, the present disclosure provides a white light emitting diode device for illumination using a near UV light and phosphors, which includes: a light emitting diode chip having a light emission peak with a wavelength range of 350 nm to 410 nm; and a light emitting unit provided on the light emitting diode chip to be excited by light irradiated from the light emitting diode chip, the light emitting unit including four kinds of phosphors, whose wavelengths are converted in blue, green, red and yellow areas, dispersed in a silicon resin:
- a blue phosphor excitable in a wavelength range of 350 nm to 410 nm and having a main light emission peak with a peak wavelength of 450 nm to 470 nm;
- a green phosphor excitable in a wavelength range of 350 nm to 410 nm and having a main light emission peak with a peak wavelength of 510 nm to 550 nm;
- a red phosphor excitable in a wavelength range of 350 nm to 410 nm and having a main light emission peak with a peak wavelength of 630 nm to 660 nm; and
- a yellow phosphor excitable in a wavelength range of 350 nm to 410 nm and having a main light emission peak with a peak wavelength of 550 nm to 590 nm.

In an embodiment of the present disclosure, the light emitting diode chip includes: a GaN-based crystal layer laminated on a sapphire substrate having an unevenness at a surface thereof; and a light emission layer provided on the GaN-based crystal layer, wherein the light emission wavelength of the light emitting diode chip has a light emission peak with a wavelength range of 350 nm to 410 nm.

In an embodiment of the present disclosure, there is provided a method for mixing three kinds of phosphors, namely a blue light emitting phosphor for emitting a blue color, a green light emitting phosphor for emitting a green color and a red light emitting phosphor for emitting a red color, at a predetermined mixture ratio by absorbing a near UV color with a semiconductor device for emitting near UV light (an LED chip), thereby obtaining color stability of white light and a high color rendering index, in which a daylight filter (which absorbs a red area from yellow light in a halogen lamp light emission wavelength) is inserted into a halogen lamp to obtain a color close to natural rays or solar rays.

In the method for implementing a light emission spectrum of a daylight filter halogen lamp, when light is irradiated to an article, high color stability and a good color rendering index may be ensured by adding four kinds of phosphors whose wavelengths are converted in blue, green, red and yellow areas, excited by the light emitted from a semiconductor light emitting diode chip.

In embodiment of the present disclosure, the LED may have a shape selected from the group consisting of a SMD shape, a LAMP shape and a COB shape.

### [Advantageous Effects]

The white light emitting diode device according to the present disclosure may give an excellent color rendering index and particularly realize a spectrum of an existing halogen light source. In addition, the white light emitting diode device according to the present disclosure has an excellent color rendering index and good light efficiency and also may control a spike and an IR light component in a blue area.

### [Description of Drawings]

Fig. 1 shows an example of a spectrum analysis result of solar rays.
Fig. 2 shows an example of a light emitting spectrum analysis result when a daylight filter is mounted to an existing halogen lamp.
Fig. 3 shows an example of a spectrum analysis result of a blue light-excited white LED.
Fig. 4 shows an example of a light emission spectrum analysis result when a daylight filter is mounted to an existing halogen lamp and a comparative spectrum analysis result of the blue light-excited white LED.
Fig. 5 shows an example of a measurement analysis result of color coordinate, color temperature, color rendering index and light efficiency of a white LED according to an embodiment of the present disclosure.
Fig. 6 shows an example of a spectral distribution analysis result of a white LED according to an embodiment of the present disclosure.
Fig. 7 shows an example of a color coordinate analysis result of a white LED having a lamp color of a color temperature of 2,200K to 3,400K according to an embodiment of the present disclosure.
Fig. 8 shows an example of a spectrum analysis result of a white LED having a lamp color of a color temperature of 2,200K to 3,400K according to an embodiment of the present disclosure.
Fig. 9 shows an example of a color rendering index analysis result of a white LED having a lamp color of a color temperature of 2,200K to 3,400K according to an embodiment of the present disclosure.
Fig. 10 shows an example of a color coordinate analysis result of a white LED having a daylight white color of a color temperature of 4,500K according to an embodiment of the present disclosure.
Fig. 11 shows an example of a spectrum analysis result of a white LED having a daylight white color of a color temperature of 4,500K according to an embodiment of the present disclosure.
Fig. 12 shows an example of a color rendering index analysis result of a white LED having a daylight white color of a color temperature of 4,500K according to an embodiment of the present disclosure.
Fig. 13 shows an example of a color coordinate analysis result of a white LED having a daylight color of a color temperature of 6,500K according to an embodiment of the present disclosure.
Fig. 14 shows an example of a spectrum analysis result of a white LED having a daylight color of a color temperature of 6,500K according to an embodiment of the present disclosure.
Fig. 15 shows an example of a color rendering index analysis result of a white LED having a daylight color of a color temperature of 6,500K according to an embodiment of the present disclosure.

### [Best Mode]

Hereinafter, an embodiment of the present disclosure will be described in detail.

In order to accomplish the above object, the present disclosure provides a white light emitting diode device for illumination using a near UV color and phosphors.

A white light emitting diode device for illumination using a near UV light and phosphors according to an embodiment of the present disclosure includes: a light emitting diode chip having a light emission peak with a wavelength range of 350 nm to 410 nm; and a light emitting unit provided on the light emitting diode chip to be excited by light irradiated from the light emitting diode chip, the light emitting unit including four kinds of phosphors, whose wavelengths are converted in blue, green, red and yellow areas, dispersed in a silicon resin:
- a blue phosphor excitable in a wavelength range of 350 nm to 410 nm and having a main light emission peak with a peak wavelength of 450 nm to 470 nm;
- a green phosphor excitable in a wavelength range of 350 nm to 410 nm and having a main light emission peak with a peak wavelength of 510 nm to 550 nm;
- a red phosphor excitable in a wavelength range of 350 nm to 410 nm and having a main light emission peak with a peak wavelength of 630 nm to 660 nm; and
- a yellow phosphor excitable in a wavelength range of 350 nm to 410 nm and having a main light emission peak with a peak wavelength of 550 nm to 590 nm.

In particular, the white light emitting diode device for illumination using a near UV light and phosphors according to an embodiment of the present disclosure allows fabricating a white light emitting diode with an excellent color rendering index without using an expensive daylight filter.

The light emitting diode chip according to an embodiment of the present disclosure includes: a GaN-based crystal layer laminated on a sapphire substrate having an unevenness at a surface thereof; and a light emission layer provided on the GaN-based crystal layer, and the light emission wavelength of the light emitting diode chip has a light emission peak with a wavelength range of 350 nm to 410 nm.

Hereinafter, characteristics of the white light emitting diode device according to an embodiment of the present disclosure will be described.

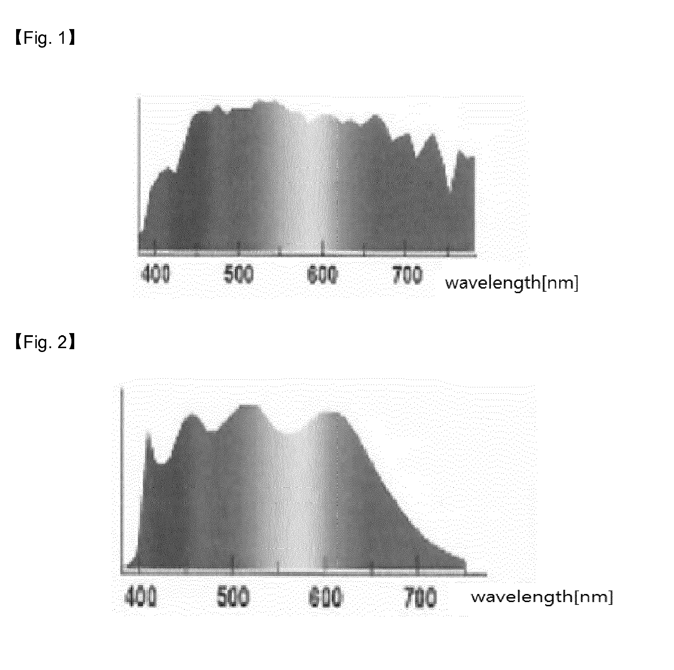

Fig. 1 shows an example of a spectrum analysis result of solar rays, and Fig. 2 shows an example of a light emitting spectrum analysis result when a daylight filter is mounted to an existing halogen lamp.

Referring to Fig. 2, it can be found that an IR component after the wavelength of 700 nm is removed, but a blue spike is still included.

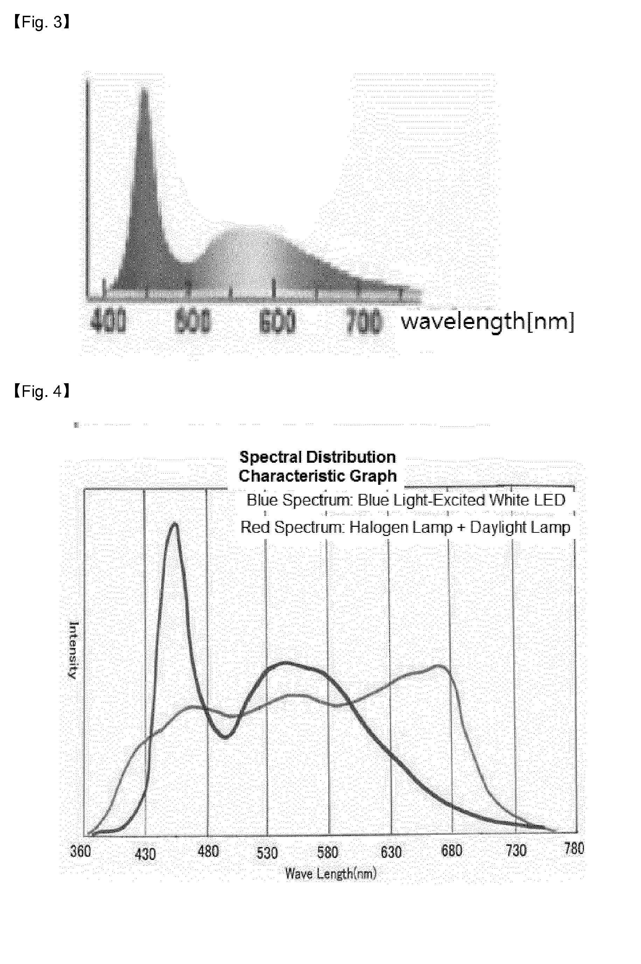

Fig. 3 shows an example of a spectrum analysis result of a blue light-excited white LED.

Referring to Fig. 3, it can be found that a very large blue spike is included.

Fig. 4 shows an example of a light emission spectrum analysis result when a daylight filter is mounted to an existing halogen lamp and a comparative spectrum analysis result of the blue light-excited white LED.

Referring to Fig. 4, when a daylight filter is mounted, characteristics similar to the solar ray spectrum may be obtained, but in this method, an expensive daylight filter should be mounted.

Therefore, the present disclosure provides a new white light emitting diode which gives an excellent color rendering index and restrains a spike in a blue area without using such an expensive daylight filter.

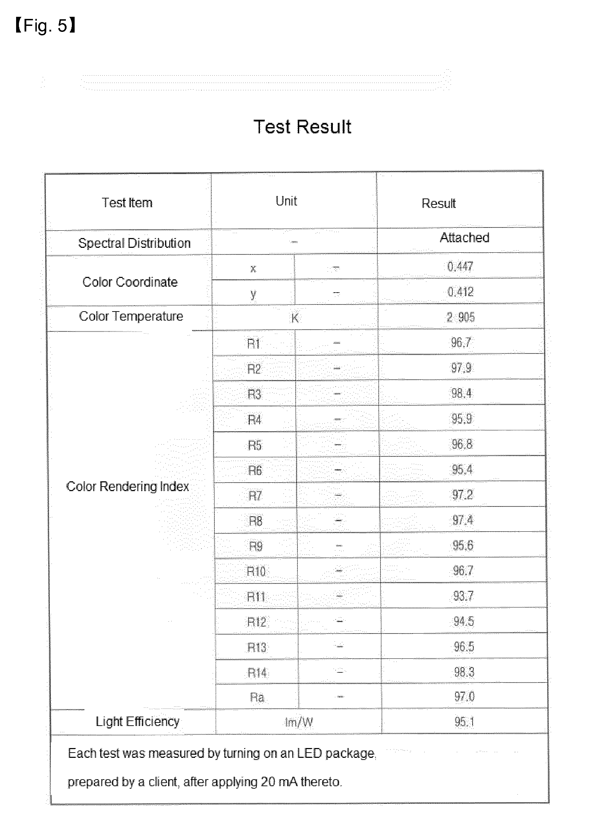

Fig. 5 shows an example of a measurement analysis result of color coordinate, color temperature, color rendering index and light efficiency of a white LED according to an embodiment of the present disclosure.

Referring to Fig. 5, it can be found that the white light emitting diode device according to an embodiment of the present disclosure accomplishes ultrahigh color rendering with an average color rendering index (Ra) of 97 at a color temperature (CCT) of 2905K and the light efficiency is 95 or above.

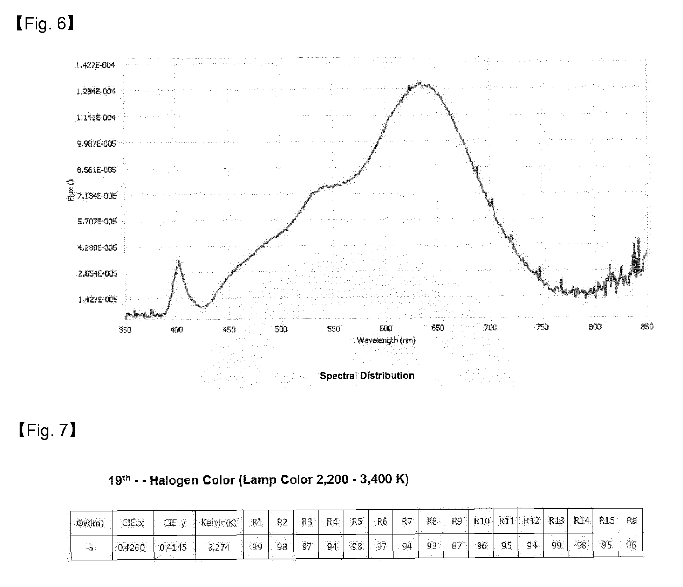

Fig. 6 shows an example of a spectral distribution analysis result of a white LED according to an embodiment of the present disclosure.

Referring to Fig. 6, it can be found that the blue spike and the IR component are restrained to the maximum in the white LED according to an embodiment of the present disclosure.

Fig. 7 shows a color coordinate analysis result of a white LED having a lamp color of a color temperature of 2,200K to 3,400K.

Referring to Fig. 7, it can be found that the white LED according to an embodiment of the present disclosure has an average color rendering index (Ra) of 96.

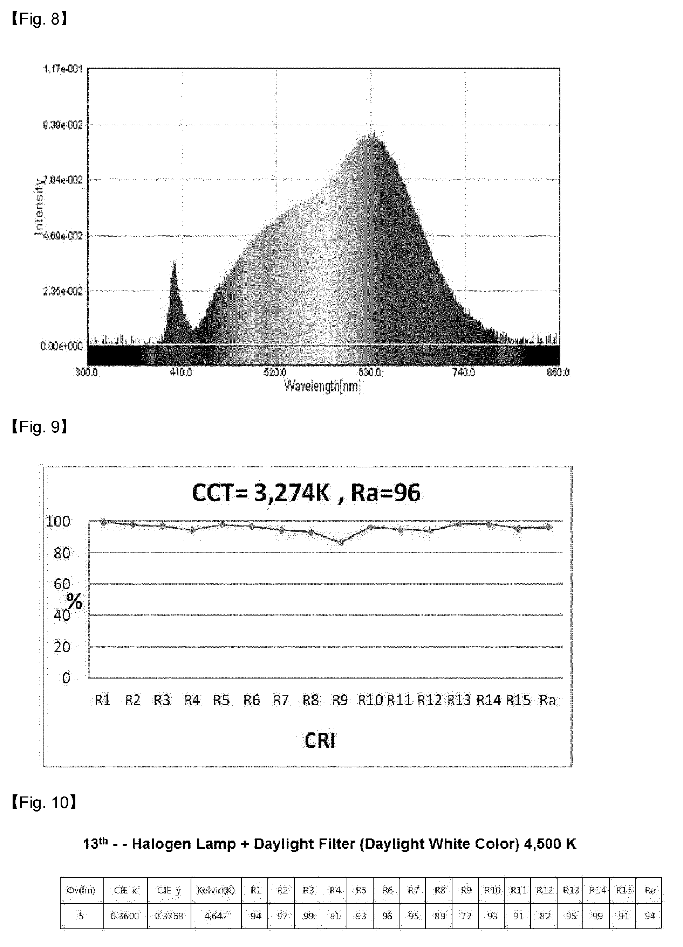

Fig. 8 shows a spectrum analysis result of a white LED having a lamp color of a color temperature of 2,200K to 3,400K according to an embodiment of the present disclosure, and Fig. 9 shows a color rendering index analysis result of a white LED having a lamp color of a color temperature of 2,200K to 3,400K according to an embodiment of the present disclosure.

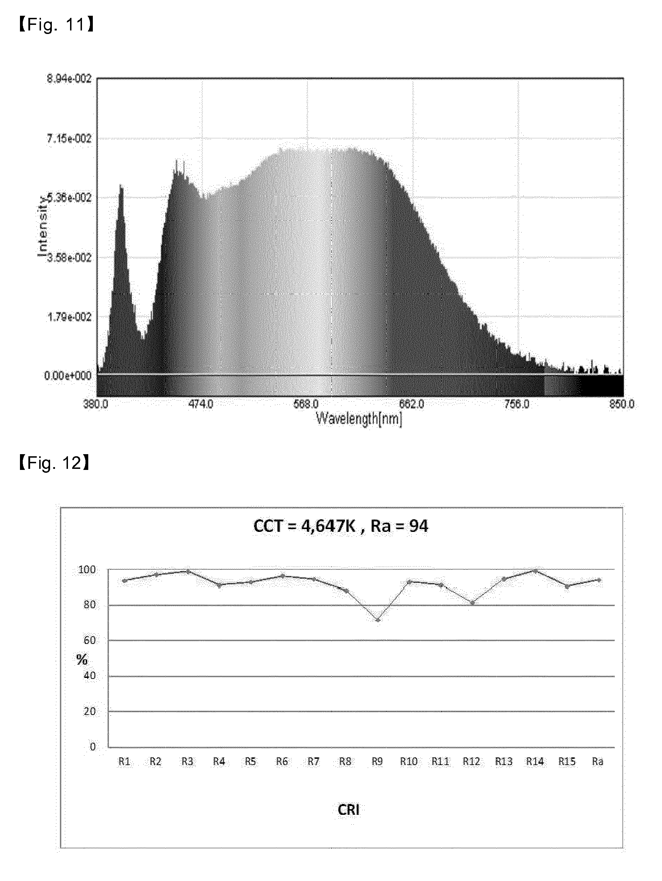

Fig. 10 shows a color coordinate analysis result of a white LED having a daylight white color of a color temperature of 4,500K according to an embodiment of the present disclosure, and Fig. 11 shows a spectrum analysis result of a white LED having a daylight white color of a color temperature of 4,500K according to an embodiment of the present disclosure.

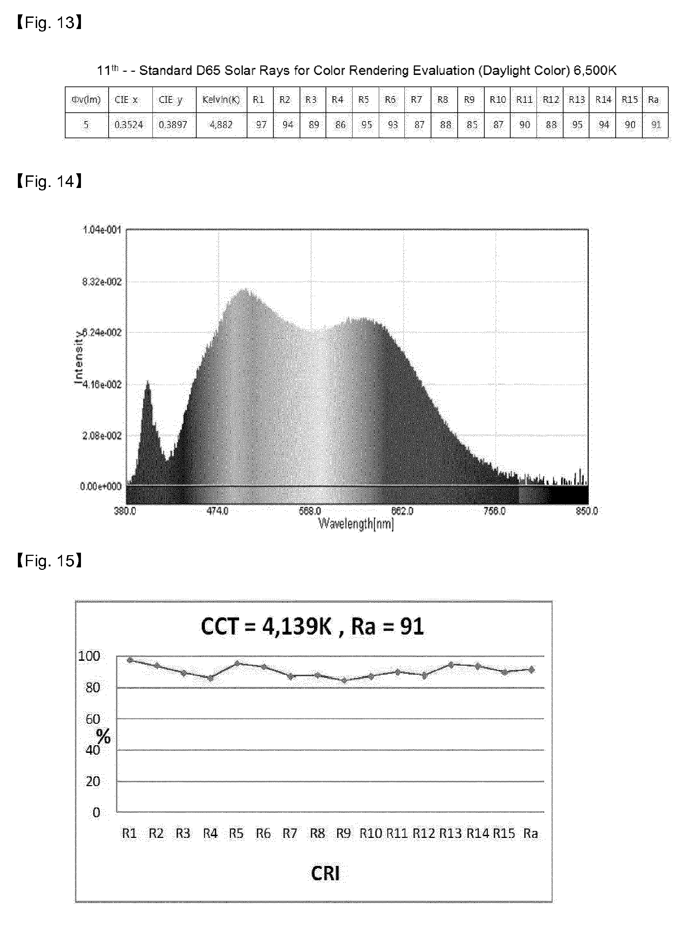

Fig. 12 shows a color rendering index analysis result of a white LED having a daylight white color of a color temperature of 4,500K according to an embodiment of the present disclosure, and Fig. 13 shows a color coordinate analysis result of a white LED having a daylight color of a color temperature of 6,500K according to an embodiment of the present disclosure.

Fig. 14 shows a spectrum analysis result of a white LED having a daylight color of a color temperature of 6,500K according to an embodiment of the present disclosure, and Fig. 15 shows a color rendering index analysis result of a white LED having a daylight color of a color temperature of 6,500K according to an embodiment of the present disclosure.

The present disclosure also proposes and implements a method for mixing three kinds of phosphors, namely a blue light emitting phosphor for emitting a blue color, a green light emitting phosphor for emitting a green color and a red light emitting phosphor for emitting a red color, at a predetermined mixture ratio at a UV LED device for emitting near UV rays by absorbing a near UV color, and thereby solving stain problem of white light and ensuring excellent color rendering. However, as a measure similar to a light emission spectrum of a daylight filter halogen lamp, an illumination device capable of improving gloss of light irradiated to an article by adding four kinds of phosphors whose wavelengths are converted in blue, green, red and yellow areas is provided.

The present disclosure has been described based on limitative embodiments, but the present disclosure is not limited to the embodiments, and various changes and modifications can be made from the present disclosure by those skilled in the art. Therefore, the scope of the present disclosure should be figured out only from the appended claims, and all equivalent modifications should be regarded as falling into the scope of the present disclosure.

## Claims

1. A white light emitting diode device for illumination using a near UV light and phosphors, the device comprising:
a light emitting diode chip having a light emission peak with a wavelength range of 350 nm to 410 nm; and
a light emitting unit provided on the light emitting diode chip to be excited by light irradiated from the light emitting diode chip, the light emitting unit including four kinds of phosphors, whose wavelengths are converted in blue, green, red and yellow areas, dispersed in a silicon resin:
- a blue phosphor excitable in a wavelength range of 350 nm to 410 nm and having a main light emission peak with a peak wavelength of 450 nm to 470 nm;
- a green phosphor excitable in a wavelength range of 350 nm to 410 nm and having a main light emission peak with a peak wavelength of 510 nm to 550 nm;
- a red phosphor excitable in a wavelength range of 350 nm to 410 nm and having a main light emission peak with a peak wavelength of 630 nm to 660 nm; and
- a yellow phosphor excitable in a wavelength range of 350 nm to 410 nm and having a main light emission peak with a peak wavelength of 550 nm to 590 nm.

2. The white light emitting diode device according to claim 1, wherein the light emitting diode chip includes:
a GaN-based crystal layer laminated on a sapphire substrate having an unevenness at a surface thereof; and
a light emission layer provided on the GaN-based crystal layer,
wherein the light emission wavelength of the light emitting diode chip has a light emission peak with a wavelength range of 350 nm to 410 nm.
